Europäisches Patentamt

European Patent Office

Office européen des brevets

(19)

(11) Publication number: **0 146 377**
**A1**

# (12) EUROPEAN PATENT APPLICATION

(21) Application number: 84308781.8

(22) Date of filing: 14.12.84

(51) Int. Cl.⁴: **G 01 R 31/36**

(30) Priority: 16.12.83 AU 2672/83

(43) Date of publication of application: 26.06.85
**Bulletin 85/26**

(84) Designated Contracting States: **DE FR GB SE**

(71) Applicant: **THE COMMONWEALTH OF AUSTRALIA, c/o the Secretary Department of Defence Support Anzac Park West Building Constitution Avenue Parkes, Canberra Australian Capital Territory 2600 (AU)**

(72) Inventor: **Muir, Brian, c/o Dept. of Communications 162 Macquarie Street, Hobart Tasmania (AU)**
Inventor: **O'Shea, John Patrick, c/o Dept. of Communications 162 Macquarie Street, Hobart Tasmania (AU)**
Inventor: **Taylor, Gregory, c/o Dept. of Communications 162 Macquarie Street, Hobart Tasmania (AU)**
Inventor: **Ferrar, Fergus, c/o Dept. of Communications 162 Macquarie Street, Hobart Tasmania (AU)**

(74) Representative: **George, Sidney Arthur et al, GILL JENNINGS & EVERY 53-64 Chancery Lane, London WC2A 1HN (GB)**

(54) **Battery testing circuit.**

(57) The invention relates to a battery testing circuit for determining the condition of a battery connected to input terminals (10, 11) of the circuit, by discharging the battery through a load (12). The discharging current is variable by means of a control circuit (15) which determines the operating point of power transistors included in thge load, so that normal discharge conditions can be simulated. The circuit includes battery voltage monitor circuit (25) which will automatically disconnect the load when the battery voltage drops to a predetermined level, and will also provide a visual and audible indication (D52, X1) of the reason for test termination. The testing circuit also includes a temperature monitor circuit (42) so that the test operation is automatically discontinued in the case of overheating. A cumulative indication of battery drain in ampere-hours is provided (13). The testing circuit operates from the battery under test and so is independent of external supplies.

COMMONWEALTH OF AUSTRALIA                          31/2145/02

BATTERY TESTING CIRCUIT

This invention relates to battery testing circuits for use in determining the effective capacity of batteries.

The invention has been particularly developed because of a need for marine surveyors to determine the effective capacity of ships' reserve batteries, particularly where nickel-cadium alkaline type batteries are encountered. That is, the testing circuit has been designed to test ships' batteries in the form of banks of cells, to ensure that the batteries are capable of maintaining an adequate state of charge. However, the present invention is not limited to this particular field of use, but is also applicable to the testing of other batteries, especially those for emergency use or ones which receive irregular use and need to be periodically checked.

There is a statutory requirement that a ship's communications equipment be capable of operating on the emergency batteries for a minimum of six hours. These batteries are separate from all other electrical power supplies on the ship. It has been usual in the past to test lead acid batteries with a hydrometer, which gives the specific gravity of the electrolyte and enables the state of charge of the batteries to be monitored. This method cannot be used with nickel-cadmium alkaline batteries. Sometimes batteries under test are discharged through a resistive load over a period of time, but in the past this method has needed close manual monitoring of the discharging operation to ensure that the batteries are not damaged.

It is an object of the present invention to provide an effective battery testing circuit which is operable by discharging of the battery and which is capable of being constructed so as to be automatically operable without the need for continual manual monitoring.

According to the present invention there is provided a battery testing circuit operative to test a battery by discharging the battery under controlled conditions, characterised by a load through which the battery is to be discharged at a selectively variable discharge rate, the load including at least one power transistor through which current from the battery being tested flows; a selectively controllable load current adjusting circuit for determining the operating point of the or each said power transistor so as to enable selective control of the battery discharge rate; a battery drain indicator circuit responsive to the load current flowing in the load and operative to indicate battery drain; and a power circuit operative to draw power from the battery being tested and to provide a regulated voltage supply for the battery testing circuit.

The provision of a load current adjusting circuit enables the precise discharge conditions of the battery to be set. The inclusion of at least one power transistor in the load enables the load current adjusting circuit to achieve its function by controlling the operating point of the power transistor(s). Furthermore, using the battery being tested as the power supply for the testing circuit enables the apparatus to be independent of other power supplies.

Preferably, the battery drain indicator circuit is operative to indicate the battery drain in ampere-hours, and preferably the indication is a cumulative indication so that at any time during a test of the battery the progressive drain of the battery is indicated.

Part of the load may comprise a cooling fan connected so as to be in operation for as long as the battery is being discharged, the cooling fan being arranged to provide cooling air flow around the power transistor(s). The power circuit may include a voltage regulator operative to be powered from the battery to provide a regulated voltage supply to the cooling fan and also to the load current adjusting circuit. This can enable normal operation of the cooling fan and the load current adjusting circuit even if the battery voltage drops below its nominal voltage level.

A load current display means may provide a display of the load current of the battery being tested, so as to enable user control of the load current adjusting circuit and thus select the battery discharge rate.

The testing circuit may further include a battery voltage monitor circuit responsive to the output voltage level of the battery and operative to generate a voltage level signal representative of the battery voltage level. The battery voltage monitor circuit is operative, if the output voltage level falls to a predetermined minimum level, to terminate the testing operating automatically, by disconnecting the load from the battery. The battery voltage monitor circuit may include a voltage fall indicator, operative to provide an indication when the predetermined minimum output voltage level has been reached and the testing operation terminated. This enables the user, when returning to check the battery testing operation, to be informed that the testing operation has been automatically terminated and the reason for such termination.

The battery voltage monitor circuit may include a voltage level detector operative to detect a battery voltage drop to the predetermined minimum level, the voltage level detector comprising a voltage comparator operative to compare the battery output voltage, or a voltage proportional thereto, with a predetermined standard voltage and to generate an output signal if the battery voltage drops to the minimum level. The voltage level detector preferably provides hysteresis so that, upon disconnection of the load from the battery occurring if the battery output voltage drops to the predetermined minimum level, any consequent battery voltage rise will not cancel the indication provided by the voltage fall indicator.

In the preferred embodiment, the battery testing circuit further includes a temperature monitor circuit operative to monitor the ambient temperature at the battery testing circuit and to generate a temperature signal if the temperature exceeds a predetermined maximum level, the temperature monitor circuit being further operative to terminate the battery testing operation automatically, by disconnecting the load from the battery, in response to generation of the temperature signal. The temperature monitor circuit preferably includes a temperature sensor circuit operative to provide the temperature signal if the sensed temperature reaches the maximum level, the temperature monitor circuit including temperature indicator means operative to generate an indication of the over-heated condition in response to generation of the temperature signal. Preferably, the temperature sensor circuit provides hysteresis so that, upon disconnection of the load from the battery occurring if the ambient temperature rises to the maximum level, any subsequent temperature drop will not cancel the overheated condition indication generated by the temperature indicator means. As before, this means that an operator returning to monitor the testing operation can be given an indication that the testing operation has been automatically discontinued and an indication of the reason for such discontinuance.

A preferred embodiment of a battery testing circuit in accordance with the present invention will now be described in greater detail, by way of example, with reference to the accompanying drawings, in which:

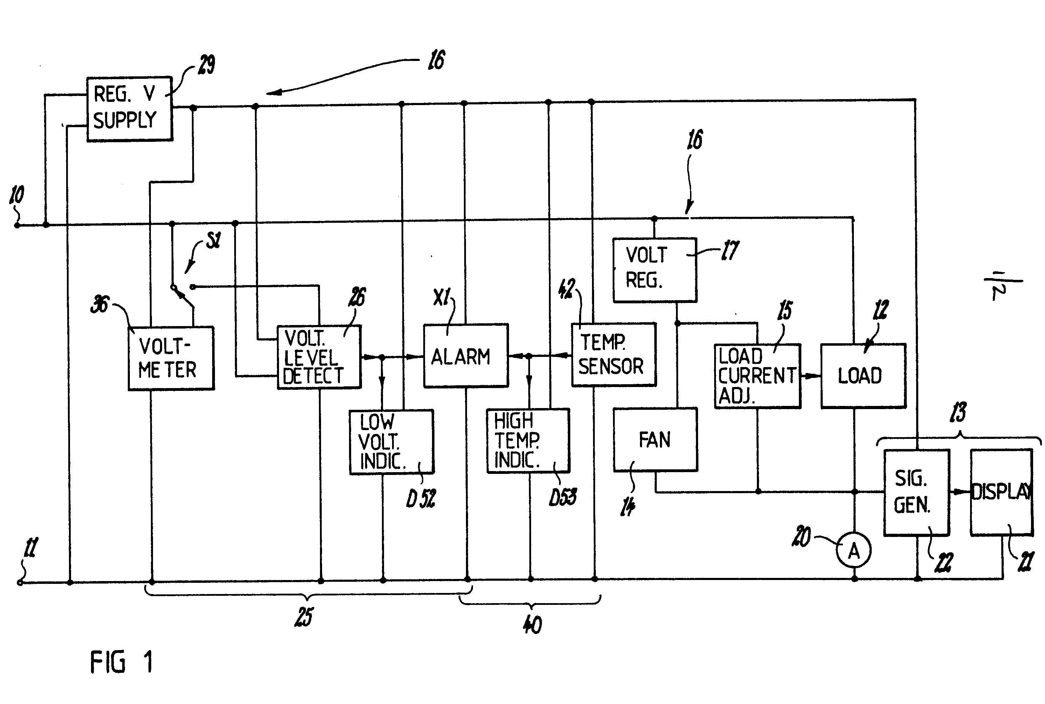

Figure 1 is a block diagrammatic view of a testing circuit according to the present invention, and

Figure 2 is a detailed circuit diagram of a possible construction of the testing circuit.

Referring to the drawings, the battery testing circuit is operable to test a battery (not shown) connected across terminals 10 and 11 by discharging the battery under controlled conditions. The testing circuit includes a load, the principal part of which is shown at 12, through which the battery is to be discharged at a predetermined rate. The testing circuit also includes a battery drain indicator circuit 13 coupled so as to be responsive to the load current drawn from the battery and operable to indicate battery drain. Throughout the specification, reference to a singular battery is intended to include a bank or array of two or more batteries and includes an array of cells. The battery drain indication given by the circuit 13 may be, for example, in ampere-hours or other suitable units.

The predetermined rate at which the battery is to be discharged through the load is selected at the start of a testing operation. The discharge rate is selectively variable so that the user can establish test conditions approximating to those that might be encountered during use of the battery. For example, the rate of discharge may be selectively variable between, say, 1.5 and 30 amps. The discharge current would normally be preset to the normal rating of the equipment being tested which, in the case of ships' batteries, would usually be between 10 and 20 amps.

The load 12 through which the battery discharges includes several (say sixteen) power transistors Q31 arranged in parallel and adapted to be supplied with power from the battery under test, each transistor being in series with a respective emitter resistor R38. The load also includes a cooling fan 14 connected so as to be in operation for as long as the battery is being discharged, the fan 14 being arranged to provide cooling air flow around the circuit components that need to dissipate heat, particularly the load transistors Q31.

To enable user selection and setting of the current drainage rate, the testing circuit includes a load current adjusting circuit 15. The circuit 15 is arranged to set adjustably the operating point of the power transistors Q31, whereby the current draw on the battery can be preselected. The fan 14 and the load current adjusting circuit 15 are supplied with power from a power circuit 16 including a voltage regulator 17 which, in turn, is powered from the battery under test. For example, the fan 14 may be provided with a regulated 14 volts supply and therefore may slow down, by design, if the equipment is operated from 16 volts or less from the battery under test. The power supply to the voltage regulator 17 is connected through a main power switch 18.

The battery testing circuit includes load current display means 20 facilitating both initial setting of the desired load current and, if desired, continuous monitoring of the discharging current during the battery test. The display means 20 conveniently comprises an ammeter located in series with the power transistors Q31.

The battery drain indicator circuit 13 as mentioned above conveniently gives an indication of the extent of battery drainage in ampere-hours. The indicator circuit 13 is preferably operable to provide a cumulative indication so that at any time during a battery test the progressive drainage of the battery can be checked. The indicator circuit 13 for this purpose conveniently includes a display counter 21 connected and operated so as to indicate a cumulative measure of battery drain.

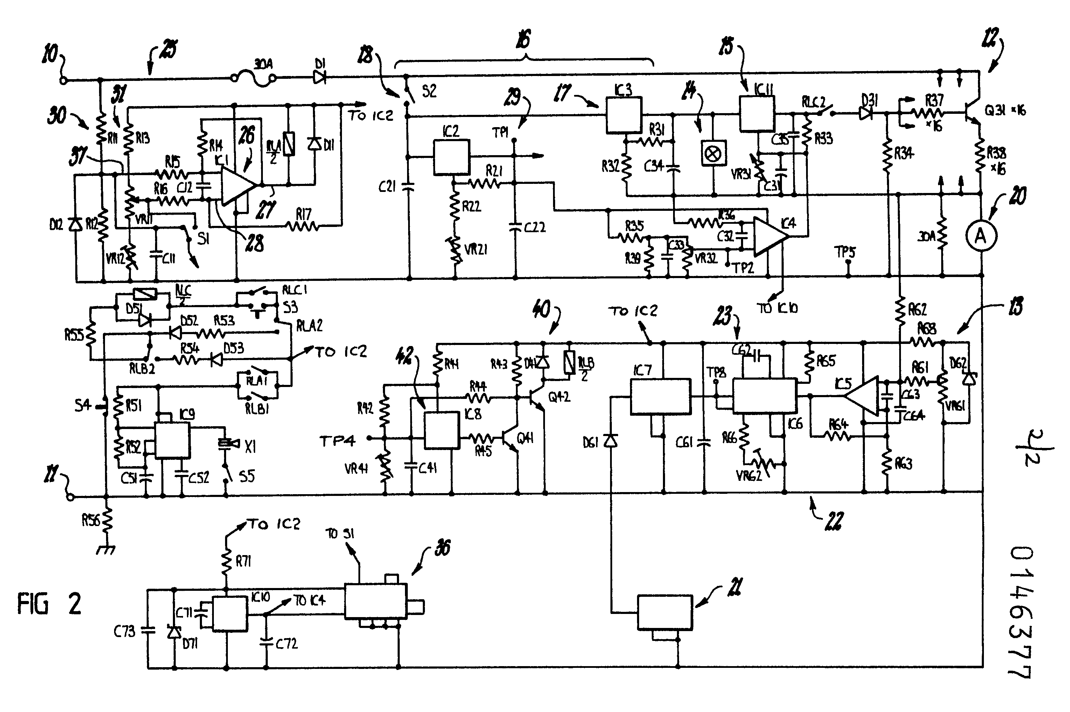

The battery drain indicator circuit 13 comprises a signal generator 22 operable to generate a drain signal dependent upon the current in the load, the drain signal being used to drive the display counter 21. The signal generator 22 in Figure 2 includes an oscillator 23 which is connected and driven in such a way that the frequency of the oscillator output signal is dependent upon the magnitude of the load current, the oscillator output being arranged to drive the display counter 21 so that the quantity displayed by the counter 21 is dependent upon both the magnitude of the load current and upon the elapsed time. Conveniently, as mentioned above, the signal generator 22 is arranged and operated so that the display counter 21 displays the battery drain in ampere-hours. The signal generator 22 may conveniently be coupled across the load current display ammeter 13.

The battery testing circuit also includes a battery voltage monitor circuit 25 responsive to the output voltage level of the battery under test and operative to generate a voltage level signal representative of the battery voltage level. If the voltage level signal indicates a battery output voltage level below a predetermined minimum, the monitor circuit 25 is operable to disconnect or initiate disconnection of the load from the battery. That is, if the output voltage level of the battery under test falls to a predetermined minimum level, the testing operation is automatically terminated. Disconnection of the load from the battery is accompanied by an indication of the battery condition given rise to termination of the test operation. The indication may comprise generation of an audible alarm signal when automatic load disconnection occurs. Alternatively, or in addition, a visual indicator may be provided which is operable so as to indicate that the predetermined minimum output voltage level had been reached and that that condition initiated termination of the test operation. The audible alarm may be provided by a piezo-buzzer X1 and the visual indication may be provided by an LED D52.

In the illustrated preferred embodiment, the battery voltage monitor circuit 25 includes a voltage level detector 26 operable to detect a battery output voltage drop to the predetermined minimum level. The voltage level detector 26 in Figure 2 comprises a voltage comparator IC1 connected and operable to compare the battery output voltage, or a voltage level proportional thereto, with a predetermined standard voltage level and to generate an output signal on a line 27 if the battery voltage drops to or beyond the predetermined minimum level. The standard voltage level applied on a line 28 is derived from a regulated voltage supply circuit 29 coupled to the battery and operable to supply a steady output voltage level, say at 7.5 volts. The battery voltage can then be applied through a resistive divider network 30 to one input of the voltage comparator IC1 and the standard voltage level derived from the regulated voltage supply circuit 29 applied to the other comparator input 28. The level at which the voltage comparator IC1 provides an output indicating that the predetermined minimum voltage has been reached is selectively adjustable. For this purpose the regulated voltage supply from the circuit 29 is applied to the respective input 28 of the voltage comparator IC1 through an adjustable resistive network 31, e.g. a voltage dividing network including a selectively variable resistance.

The voltage level detector 26 provides some hysteresis by means of a resistor R14 so that, upon disconnection of the load from the battery occurring if the battery output voltage drops to the predetermined level, any consequent voltage rise will not cancel the audible or visual signals generated. The hysteresis may be of the order of four volts in a typical circuit.

The output of the voltage level detector 26 is connected to a relay coil RLA/2 which is arranged to operate one switch RLA1 which connects a voltage from the regulated voltage supply 29 to the audible alarm X1 and another switch RLA2 which connects the regulated voltage supply to the indicating LED D52. The relay switch RLA2, which is arranged to supply power to the LED D52, in switching over upon energisation of the coil RLA/2, disconnects power from a relay coil RLC/2 which in turn maintains, during normal operation, a switch RLC2 between the load current adjusting circuit 15 and the load 12 in a closed condition and hence maintains the load 12 connected to the battery. That is, upon falling of the battery voltage to the predetermined minimum level, the load 12 is disconnected from the battery and audible and visual indications are generated and maintained until the circuit is reset.

The battery voltage monitor circuit 25 also includes a voltmeter 36 operable to monitor the output voltage of the battery under test. The voltmeter 36 is, for example, a digital voltmeter supplied with power from the regulated voltage supply 29 and connected across the battery terminals or, as shown in Figure 2, to a point 37 where the voltage is proportional to the battery output voltage, to provide a continuous indication of the battery output voltage. The voltmeter 36 is connected so as to be capable of being selectively connected across the voltage level detector 26, enabling selective monitoring of the predetermined minimum voltage at which the voltage level detector 26 is to be triggered during the setting thereof. This is achieved by providing a

changeover switch S1 at one terminal of the voltmeter 36 which enables selection of either the battery output voltage or the standard voltage as applied on line 28 to the voltage comparator IC1 to be displayed by the voltmeter 36 for monitoring purposes.

The battery testing circuit according to the preferred embodiment of the present invention also includes a temperature monitor circuit 40 operable to monitor the ambient temperature at the battery testing circuit and to generate an appropriate signal if the temperature exceeds a predetermined maximum level. The provision of temperature monitoring circuit 40 is desirable, since the circuit may be used where there is high power dissipation where overheating of components may be undesirable. The temperature monitor circuit 40 includes a temperature sensor circuit 42, supplied from the regulated voltage supply 29 for example, and operable to provide an output signal if the sensed temperature reaches a predetermined maximum. The temperature at which the temperature sensor is triggered is selectively variable by means of a resistor VR41. The output signal is used to generate an indication of the overheating condition and is also used to disconnect the load 12 from the battery. The indication of the overheating comprises an audible alarm generated by generator X1. Also, a visual indication of overheating is provided by means of an LED D53. The audible alarm is the same as the audible alarm used for low battery output voltage indication, but the visual indication provided by the overheating indicating LED D53 is separate from the low battery voltage indicator LED D52, so that an operator upon returning to the equipment can be provided with an indication of whether the circuit operated to disconnect the load 12 in response to battery output voltage drop, or in response to equipment overheating. The temperature sensing circuit 42 is arranged to energise a relay coil RLB/2 if the sensed temperature reaches a predetermined maximum, the relay coil RLB/2 operating one switch RLB1 arranged to supply power from the regulated voltage supply 29 to the audible alarm generator X1. The relay coil RLB/2 is also operable to operate a switch RLB2 simultaneously, so as to disconnect power from the relay coil RLC/2 operating the switch RLC2 between the load current adjusting circuit 15 and the load 12, thereby disconnecting the load 12 from the battery, and to connect the regulated voltage supply 29 through the overheating indicating LED D53 to earth.

The need for temperature sensing will be appreciated when it is pointed out that the temperature rise of expelled air during battery discharge may be approximately 10°C above ambient for each 350 watts of dissipation. In the case of 24 volt batteries being tested at 30 amp discharge, the temperature rise of expelled air will be approximately 20°C.

The operation of the detailed circuit shown in Figure 2 will now be described.

Initially, during operation of the Figure 2 battery testing circuit, the main power switch S2 and the alarm switch S5 would be open. The opening of the main power switch S2 disconnects the battery under test from the regulated voltage supply circuit 29 (IC2 etc.) and from the load current adjusting circuit 15 (IC11 etc.) and hence from the sixteen power transistors Q31. The voltage at which the voltage comparator IC1 will cause energisation of the relay coil RLC/2 is determined by the setting of the potentiometer VR11, which can be set initially to a minimum. A variable resistor VR31 which sets the operating point of the power transistors Q31, and hence the load current to be drawn, will also be set initially to minimise the load current. Also, the ampere-hour counter 21 will initially be reset to 0.

After these initial operations, the input terminals 10 and 11 can be connected to the battery to be tested. Also at this stage the surroundings of the apparatus should be checked to remove loose debris which may be drawn into the housing of the circuitry by the fan.

The main power switch S2 is then closed, thus energising the voltage regulator 17 (IC8 etc.), which in turn will cause the fan 14 to commence operation. Also, closure of the main power switch S2 will energise the regulated voltage supply 29 (IC2 etc.) and the voltage converter IC10 supplying a regulated negative voltage so that a voltage will now be applied, for example, to the digital voltmeter 36.

The "load-on" which S3, which also functions as a reset switch, and which is a normally-open press-button switch, can then be closed. This applies power from the regulated voltage supply 29 to the relay coil RLC/2, which in turn will close the switches RLC1 and RLC2. The closure of the switch RLC1 will maintain the power applied to the relay coil RLC/2 after release of the switch S3 and the closure of the switch RLC2 will cause the application of a bias potential to the power transistors Q31, thereby commencing current flow through the transistors.

After the load 12 is connected to the battery by temporary closure of the switch S3, the variable resistor VR31 can be adjusted until the desired current drain on the battery is indicated on the ammeter 20. At this time, the ampere-hour counter 21 should begin to increment. The counter 21 is driven from an amplifier IC5, a voltage-controlled oscillator IC6 (the output of which is a relatively high frequency signal, say in the range 14 to 800 Hz) and a divider IC7 (which divides the pulse output of IC6 to a value suitable to drive the counter 21). The ampere-hour counter 21 may be provided with its own backup supply battery (not shown) so that readings can be retained. This is desirable for several reasons. For example, if a battery cell fails during the test operation, that cell can be replaced and the test resumed without losing information concerning battery drain to the point when the cell failure occurred.

The switch S1, which is normally connected as shown in Figure 2 so that the voltmeter 36 is indicating the test battery output voltage, can be switched over to cause the voltmeter 36 to indicate the standard reference voltage being applied on line 28 to the input terminal of the comaprator IC1, that standard reference voltage representing the predetermined minimum voltage at which the testing circuit will be operable to disconnect the load 12. The potentiometer VR11 can then be adjusted until the desired low voltage trip level is displayed on the voltmeter 36. The switch S1 is then released to return to the position shown in Figure 2, so that the voltmeter 36 will thereafter continuously provide an indication of the battery output voltage level.

Finally, the alarm switch S5 can be closed to enable operation of the piezo alarm generator X1.

The switch S4, which is a push-button normally-closed switch, can be operated at any time to disconnect the load 12 quickly from the battery. This disconnection is achieved since opening of the switch S4 will interrupt the power from the regulated voltage supply 29 through the relay coil RLC/2, the relay coil RLC/2 controlling the operation of the switch RLC2 between the load current adjusting circuit 15 and the bases of the power transistors Q31.

If at any time during a battery test the output voltage of the battery drops to the preset minimum value, the relay coil RLA/2 will be energised and the switches RLA1 and RLA2 will change over from the normal states shown in Figure 2. Closure of the switch RLA1 will connect the regulated voltage supply 29 to the piezo alarm X1, which will provide an intermittent signal due to operation of a slow square-wave generator IC9. Changeover of the switch RLA2 will firstly disconnect the regulated voltage supply 29 from the relay coil RLC/2 thus removing bias from the bases of power transistors Q31 and will simultaneously connect the regulated voltage supply 29 to the LED D52. The hysteresis in the operation of the voltage level detector circuit will prevent any consequent rise in battery output voltage level from de-energising the relay coil RLA/2 and hence disconnecting the supply from the audible alarm X1 and the visual indicator D52. Even if the relay coil RLA/2 is re-energised, the load 12 will not be reconnected to the battery, because the switch RLC1 will remain open, and it would be necessary for the operator to close the switch S3 to connect the load 12 again to the battery.

The temperature monitor circuit 40, including a temperature indicator circuit IC8 which is mounted on a separate board in the air draught through the circuit housing, is operable to energise the relay coil RLB/2 if the sensed temperature rises above a predetermined maximum level. The temperature at which the IC8 causes energisation of the coil RLB/2 is set by connecting a meter to a test point TP4 and adjusting VR41. A resistor R44 provides the hysteresis in operation of the temperature monitor circuit 40. Energisation of the coil RLB/2 will cause closure of the switch RLB1, thus energising the audible alarm X1, and changeover of the switch RLB2, thus both de-energising the coil RLC/2 and energising the excess temperature indicating LED D53.

For as long as current is flowing in the load 12, the signal generator 22 of the battery drain indicator circuit 13 is providing a drain signal of a frequency dependent on the load current. The display counter 21 accumulates the drain signal to provide a continuous read-out of net battery drain in ampere-hours.

IC4 is a voltage comaprator, and together with the associated components functions as an auto-current limiter, set at, say, 30 amps. That is, the circuit senses the voltage across the ammeter 20, and once 30 amps is reached the output goes low and shunts VR31.

The remaining components of the circuit in Figure 2 and details of the broadly-described blocks of the circuit will be understood by those skilled in the art. Exeamples of suitable components for the integrated circuits are as follows:

Voltage comparators IC1, IC4: LM311

Voltage regualtors IC2, IC3, IC11: LM317K

Fixed-gain amplifier IC5: LM358

Voltage-controlled oscillator IC6: 4046

Divider IC7: 4020

Temperature indicator IC8: LM3911

Slow square-wave generator IC9: LM555

Voltage converter IC10: ICL7660

One function of the Figure 2 circuit not described so far is that any supply interruption, e.g. due to sparking or arcing, will cause the load 12 to be dropped out of circuit. This occurs since the relay coil RLC/2 will be de-energised. Such interruption will not necessarily cause alarm generation. In the case of such load drop-out, restarting will be necessary by temporary closure of the switch S3.

The circuit shown in the drawings can be used to discharge batteries at a continuously adjustable constant current rate. The voltage output of the battery under test can be constantly monitored, as can the load current and the ampere-hours. Due to the time-consuming nature of a battery discharge test, automatic functions have been built in to enable for example a surveyor of a ship's reserve batteries to carry on with other work, without fear of battery damage occurring if the voltage drops. The circuit in the drawings is protected from over-temperature operation and from reversal of polarity (by diode D1).

Furthermore, the load current can be switched on or off at any time with the push-button switches S3 and S4, without reducing the current first. Any alarm condition caused by battery output voltage dropping or by excess temperature will return the instrument to a standby state. Load current cannot be drawn again until the alarm-creating condition is rectified. That is, if the fault condition persists and the switch S3 is closed, RLC/2 cannot operate to reconnect the load. Both the temperature and low voltage alarm functions have built-in hysteresis. Momentary switch-off from stand-by will clear the alarm condition, provided that the cause is removed.

As an example of operation of the over-temperature facility, the instrument may reach 60°C and may shut down if operated in very hot temperatures at, say, 30 amps discharge. Operation at a lower current can be carried out after a period on stand-by.

Also, it will be appreciated that the low voltage trip level as set by resistor VR11 can be readjusted to any desired voltage below the battery output voltage during the battery discharge operation. Nickel-cadmium batteries should not be discharged below 1.1 volts per cell.

After a battery testing operation in which the battery has been run at its rated current output for the predetermined time, say six hours, the battery or array of batteries can then be recharged if the test has been passed. If not, the cells can be inspected and faulty ones replaced. For example, cells may be faulty because of electrolyte contamination, poor charge levels and cell damage.

The utilisation of the battery under test as the power supply for the circuitry makes the apparatus independent of other external power supplies.

## CLAIMS

1. A battery testing circuit operative to test a battery by discharging the battery under controlled conditions, characterised by a load (12) through which the battery is to be discharged at a selectively variable discharge rate, the load including at least one power transistor (Q31) through which current from the battery being tested flows; a selectively controllable load current adjusting circuit (15) for determining the operating point of the or each said power transistor (Q31) so as to enable selective control of the battery discharge rate; a battery drain indicator circuit (13) responsive to the load current flowing in the load and operative to indicate battery drain; and a power circuit (16) operative to draw power from the battery being tested and to provide a regulated voltage supply for the battery testing circuit.

2. A circuit as claimed in claim 1, characterised in that the battery drain indicator circuit (13) is operative to indicate the battery drain in ampere-hours.

3. A circuit as claimed in claim 2, characterised in that the battery drain indicator circuit (13) is operative to provide a cumulative indication of battery drain in ampere-hours so that at any time during a test of the battery, the progressive drain of the battery is indicated.

4. A circuit as claimed in any preceding claim, characterised in that the load (12) further includes a cooling fan (14) connected so as to be in operation for as long as the battery is being discharged, the cooling fan being arranged to provide cooling air flow around the or each power transistor (Q31).

5. A circuit as claimed in claim 4, characterised in that the power circuit (16) includes a voltage regulator (17) to be powered from the battery being tested to provide a regulated voltage supply to the cooling fan (14) and to the load current adjusting circuit (15).

6. A circuit as claimed in any preceding claim, characterised by load current display means (20) operative to provide a display of the load current of the battery being tested so as to enable user control of the load current adjusting circuit (15) so as to select the battery discharge rate.

7. A circuit as claimed in any preceding claim, characterised by a battery voltage monitor circuit (25) responsive to the output voltage level of the battery being tested and operative to generate a voltage level signal representative of the battery voltage level, the battery voltage monitor circuit being operative if the output voltage level falls to a predetermined minimum level to terminate the testing operation automatically by disconnecting the load (12) from the battery.

8. A circuit as claimed in claim 7, characterised in that the battery voltage monitor circuit (25) includes a voltage fall indicator (D52, X1) operative to provide an indication when the predetermined minimum output voltage level has been reached and the testing operation terminated.

9. A circuit as claimed in claim 8, characterised in that the battery voltage monitor circuit (25) includes a voltage level detector (26) operative to detect a battery voltage drop to said predetermined minimum level, the voltage level detector comprising a voltage comparator (IC1) operative to compare the battery output voltage or a voltage proportional thereto with a predetermined standard voltage and to generate an output signal if the battery voltage drops to the predetermined minimum level.

10.  A circuit as claimed in claim 9, characterised in that the voltage level detector (26) provides hysteresis so that, upon disconnection of the load (12) from the battery occurring if the battery output voltage drops to the predetermined minimum level, any consequent battery voltage rise will not cancel the indication provided by the voltage fall indicator (D52,X1).

11.  A circuit as claimed in any preceding claim, characterised by a temperataure monitor circuit (40) operative to monitor the ambient temperature at the battery testing circuit and to generate a temperature signal if the temperature exceeds a predetermined maximum level, the temperature monitor circuit being further operative to terminate the battery testing operation automatically by disconnecting the load (12) from the battery in response to generation of the temperature signal.

12.  A circuit as claimed in claim 11, characterised in that the temperature monitor circuit (40) includes a temperature sensor circuit (42) operative to provide the temperature signal if the sensed temperature reaches the predetermined maximum level, the temperature monitor circuit (40) including a temperature indicator means (D53,X1) operative to generate an indication of the overheated condition in response to generation of the temperature signal.

13.  A circuit as claimed in claim 12, characterised in that the temperature sensor circuit (42) provides hysteresis so that, upon disconnection of the load (12) from the battery occurring if the ambient temperature rises to the maximum level, any subsequent temperature drop will not cancel the overheated condition indication generated by the temperature indicator means (D53,X1).

FIG 1

FIG 2

0146377

2/2

## EUROPEAN SEARCH REPORT

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | US-A-3 907 398  (JAMES O. HEBERT, Jr. et al.)<br>* Figure 3; column 3, lines 17-37; column 7, lines 1-11, 19-32; column 8, lines 46-68; clumn 9, lines 1-6 * | 1-3 | G 01 R   31/36 |
| A | | 6-9,11,12 | |
| Y | US-A-4 086 524  (MANFRED KREMER)<br>* Abstract; figures 1,2; claim 1 * | 1-3 | |
| A | | 5 | |
| A | US-A-3 593 099  (HANS K. SCHOLL)<br><br>* Column 2, lines 26-70; column 3, lines 5-21; column 4, lines 31-40; column 6, lines 2-12; claims 1,2; figures 4-7 * | 1-4,6-9 | TECHNICAL FIELDS SEARCHED (Int. Cl.4)<br><br>G 01 R<br>H 01 M |
| A | GB-A-1 400 159  (HAWKER SIDDELEY AVIATION LTD.) | | |

The present search report has been drawn up for all claims

| Place of search | Date of completion of the search | Examiner |
|---|---|---|
| THE HAGUE | 11-03-1985 | KAUFFMANN J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03.82